Europäisches Patentamt

European Patent Office

Office européen des brevets

(11) Publication number: **0 431 701 A2**

# EUROPEAN PATENT APPLICATION

(21) Application number: 90203189.7

(51) Int. Cl.5: **G03F 7/16**, G03F 7/11

(22) Date of filing: 03.12.90

(30) Priority: 04.12.89 JP 315854/89

(43) Date of publication of application:
**12.06.91 Bulletin 91/24**

(84) Designated Contracting States:
**DE FR GB NL**

(71) Applicant: NIPPON PAINT CO., LTD.
1-2, Oyodokita 2-chome Kita-ku
Osaka-shi(JP)

(72) Inventor: Sakurai, Kiyomi
24-11, Yawatayamada
Yawata-shi, Kyoto-fu(JP)
Inventor: Yamagami, Yoshikazu
573, Okada
Sennan-shi, Osaka-fu(JP)

(74) Representative: Smulders, Theodorus A.H.J.,
Ir. et al
Vereenigde Octrooibureaux Nieuwe Parklaan
107
NL-2587 BP 's-Gravenhage(NL)

(54) A method for forming a photoresist with a cover coat.

(57) An improved method for forming a photoresist with a cover coat comprising forming a photosensitive resinous layer on a conductive board by an anionic electrodeposition coating means, washing with water, dipping the coated board into a water dispersion comprising 100 to 30% by weight (in solid) of an acrylic polymer of perfluoro alkyl acrylate or methacrylate and other $\alpha,\beta$ -ethylenically unsaturated monomer and 0 to 70% by weight (in solid) of a water soluble high molecular weight compound, pH of which is controlled in 7.0 to 9.0, and finally drying. In this method, only one drying operation is required at the final stage.

EP 0 431 701 A2

# A METHOD FOR FORMING A PHOTORESIST WITH A COVER COAT

## Field of invention

The present invention relates to a method for forming a photoresist film having a cover-coat, comprising forming a photoresist film on a conductive base material by an anionic electrodeposition means and dip-coating an aqueous dispersion of a high molecular weight substance thereupon.

## Background of the invention

In the production of a printed circuit board and the like, has been commonly accepted a method wherein a photoresist film is formed on a copper plated or cladded laminate, on which the desired circuit pattern is formed by a photo-exposure means, and the exposed material is subjected in successive order, to development, etching and resist peeling. Various methods have been proposed to obtain such photoresist film, but the most attractive one is the formation of photoresist film through an electrodeposition coating means.

Such method is very attractive in that the desired photoresist film can be formed on any conductive base material regardless of its surface smoothness, by using an automated production means on a large scale and on a continuous basis, and thus formed photoresist is excellent in resolving power because of its thin and uniform nature. However, these are problems such that the formed thin layer is liable to be easily inspired and since the layer is of considerable tacky nature, it often causes the contamination of pattern mask to be contacted and the breakage of the resist film through blocking of contiguous film surfaces. As a solution of said problems, in Japanese Patent Publication (unexamined) Sho 63-60594, there describes a method wherein a solution of water-soluble resin is applied on a photo curable, electrodeposition coating.

In that method, since a water soluble resin as polyvinyl acetate is used as a cover coat, the formed cover-coat will absorb moisture under high humidity conditions, resulting undesired tackiness of the coating, and there often causes uneven thickness of such coating at the time of dip-coating of such resinous solution. This is because since the electrodeposited photoresist film surface is mainly composed of an oleophilic resin containing, a quantity of acrylate monomer and oligomer, and hence is of water repellent nature, a uniform cover coat can hardly be obtained by dipping the photoresist film into an aqueous solution of a water soluble resin.

Also above Japanese Patent Publication said that the cover coating process with water soluble resin was going to be done after electrodeposition coating, rinsing and drying, then followed by another drying process. That is, known cover-coating process requires twice of drying process, which is before and after cover coating process.

It is, therefore, an object of the invention to provide an improved method for forming a photoresist film with a cover coat by using a dip-coating means with an aqueous solution or dispersion of a high molecular weight substance, and also to provide simple process which is able to eliminate second drying process.

## Summary of the invention

According to the invention, the abovementioned object can be attained with an improved method for forming a photoresist film with a cover coat, which comprises forming a photoresist film on a conductive board by dipping the board into an aqueous solution or dispersion of a photosensitive resinous composition and effecting an anionic electrodeposition, washing, then dipping the washed board into an aqueous dispersion of 100 to 30% by weight (in solid) of an acrylic polymer of perfluoro alkyl acrylate or methacrylate and other $\alpha$ , $\beta$ -ethylenically unsaturated monomer and 0 to 70% by weight (in solid) of a water-soluble high molecular weight compound, controlled at pH 7.0 to 9.0, and drying the coated board. As already stated, a photoresist film with a cover coat has already been known and such product has advantageously been prepared by a method comprising dipping a conductive board into a water solution or dispersion of a photosensitive resinous composition and effecting an anionic electrodeposition to obtain a photoresist film on said board, washing, dipping the washed board into an aqueous solution or dispersion of high molecular weight substance and then drying the coated board.

During studies of such methods, the inventors have surprisingly found that since the structural resin of anionically electrodeposited photoresist has a high acid value, a uniform cover coat can be formed on the water-repellent photoresist film surface by using an aqueous solution or dispersion of high molecular weight substance, whose pH is controlled in a range of 7.0 to 9.0.

From the stand-view of desired tackiness-proof property, blocking resistance and contamination resistance of thin cover coat, the inventors have found an optimum water dispersion of high molecular weight substance for said cover coat. On the basis of these findings, the invention has been made. Furthermore, the inventors have found that by the adoption of the present aqueous dispersion of high molecular weight substance, it is possible to obtain a photoresist film having a uniform cover coat by the simple method wherein a conductive board is covered with a photosensitive resin layer by an anionic electrodeposition means, washed with water and then the washed board is, without drying, directly dip-coated with the abovementioned aqueous dispersion of high molecular weight substance and finally dried.

In contrast to the known process as proposed in Japanese Patent Publication (unexamined) Sho 63-60594 wherein the electrodeposited board is washed with water, dried at 70°C for 10 minutes and then the dried board is dipped into an aqueous dispersion of water soluble resin and thus coated board is again dried at 100°C for 3 minutes, the present process adopts with only one drying step, thereby obtaining the desired photoresist film with cover coat. This is very important and advantageous feature of the present invention.

Preferred embodiments of the invention

In this invention, a photoresist film is formed on a conductive board by an anionic electrodeposition means with an aqueous solution or dispersion of a photosensitive resinous composition.

As the photosensitive resinous composition, any of the known anionically electrodepositable photosensitive resinous compositions may be satisfactorily used. They may be of either photo-curing type or photo-decomposition type. The photo-curing type photosensitive resinous composition may comprise a high molecular weight binder resin having an acid value, acrylic monomer or oligomer having polymerizable unsaturation bonds, a photo-polymerization initiator and a heat polymerization inhibitor.

Preferably, the high molecular weight binder resin is a water soluble or dispersible resin having an acid value of 30 to 200 and an average molecular weight of 1,000 to 50,000. Such resin may include in its polymer chain an acryloyl or methacryloyl group. Examples of such resin are acrylic copolymer obtained by the co-polymerization of an acid group containing monomer as acrylic acid, methacrylic acid and the like, and other monomers as alkyl acrylate, alkyl methacrylate and the like.

As the acrylic monomer or oligomer having polymerizable unsaturation bond, photo polymerization initiator and heat polymerization inhibitor, any of the known compounds customarily used in the related field may be satisfactorily used.

Preparation of an aqueous, electrodeposition bath with such photo-curing type resinous composition can be practiced by following the technique described in, for example, Japanese Patent Publication (unexamined) Sho 61-80240, ibid 61-247090 and the like.

Besides the above, a photo-decomposition type resinous composition may also be used. Examples of photo-decomposition type, anionically electrodepositable resinous composition aqueous solutions or dispersions of are o-quinone diazide, containing resins or resinous mixture of water soluble or dispersible resin and o-quinone diazide compound as described in, for example, Japanese Patent Publication (unexamined) Sho 61-206293, ibid 63-141048 and the like.

In the preparation of a photoresist film, a conductive board as copper plated or cladded laminate is dipped into an aqueous solution or dispersion of anionically electrodepositable, photo-curing type or photo-decomposition type photosensitive resinous composition, and effecting an electrodeposition by connecting the board to an anode and charging a direct current (30 to 400 Volts) for 30 seconds~ 5 minutes, to deposit on the copper base plate the photosensitive resinous component of said solution or dispersion.

After washing with water to remove the remaining electrodeposition bath liquid, the washed board is dipped into an aqueous dispersion of a high molecular weight substance to form a cover coat. However, as the most important characteristics of the invention, a specific high molecular weight substance is used as a covering component.

That is, the aqueous dispersion used is a water dispersion comprising 100 to 30% by weight (in solid) of an acrylic polymer or acrylic copolymer of perfluoro alkyl acrylate or methacrylate and other $\alpha,\beta$-ethylenically unsaturated monomer and 0 to 70% by weight (in solid) of a water-soluble high molecular weight compound, whose pH is controlled in a range of 7.0 to 9.0.

Examples of said perfluoro alkyl acrylate or methacrylate are perfluoro-octyl ethyl acrylate, perfluoro-octyl ethyl methacrylate, perfluoro-heptyl ethyl acrylate, perfluoro-heptyl ethyl methacrylate and the like. Examples of other copolymerizable $\alpha,\beta$-ethylenically unsaturated monomers are acrylic acid, methacrylic acid and their alkyl esters as methyl, ethyl, propyl, butyl, isobutyl, 2-ethylhexyl, octyl, hexyl, decyl, lauryl, stearyl, $\beta$-hydroxyethyl, $\beta$-hydroxy propyl, and the like.

3

An aqueous emulsion obtained by effecting an emulsion polymerization of the abovementioned monomers in water or dispersing a polymer solution obtained by a solution polymerization of these monomers in water by a post-emulsification means may be satisfactorily used. Such products are available at the market as, for example, Asahi Guard AG-710 (trademark, manufactured by Asahi Glass Co.), DIC Guard F-60, and F-70 (trademark, manufactured by Dainippon Ink Chem. Co.), Scotch Guard FC-232 (trademark, manufactured by Sumitomo Three-M Co.) and the like.

The present aqueous high molecular weight substance bath may or may not contain a water soluble high molecular weight compound, as, for example, polyvinyl alcohol, partially saponified polyvinyl acetate, polyvinyl acetate, styrene-maleic anhydride co-polymer, ethylene-maleic anhydride co-polymer, isobutylene-maleic anhydride co-polymer, methyl vinyl ether-maleic anhydride co-polymer, methyl cellulose, ethyl cellulose, hydroxyethyl cellulose, hydroxy propyl methyl cellulose and the like, as a viscosity regulator, to improve application characteristics of the coating composition. Advantageously, the present dip-coating aqueous dispersion may contain 100 to 30% by weight (in solid) of the abovementioned, perfluoro alkyl group containing acrylic polymer and 0 to 70% by weight (in solid) of the abovementioned, water soluble high molecular weight compound.

Usually, the said aqueous dispersion may be diluted with water at an appropriate solid content, e.g. 1 to 10% by weight, by due consideration of liquid viscosity, application easiness and the like.

However, it is essential that the pH of said dispersion should be controlled in a range of 7.0 to 9.0, otherwise the desired uniform coating cannot be obtained.

The cover coat desired may be easily obtained by dip-coating means with the abovementioned aqueous dispersion. The dipping time is usually 5 seconds to 60 seconds, but this is not critical in the invention. After effecting said dipping, the coated board is taken out and subjected to drying to obtain the desired cover coat of 0.5 to $5\mu$ thickness. Thus obtained photoresist film with a cover coat is excellent in blocking resistance and free from undesired tacky properties, and is very useful for the production of printed circuit board by the subsequent exposure, development, etching and peeling operations.

The invention shall be now more fully explained in the following Examples. Unless otherwise being stated, all parts and percentages are by weight.

## Manufacturing Example 1

60 parts of an acrylic resin derived from 55 parts of methyl methacrylate, 38 parts of butyl methacrylate and 7 parts of methacrylic acid, having an acid value of 45 and an average molecular weight of about 10,000, 20 parts of trimethylolpropane tri-methacrylate, 20 parts of pentaerythritol tetra acrylate, 5 parts of 2,2-dimethoxy-2-phenyl acetophenone and 0.4 part of p-methoxyphenol were added to and dissolved in 50 parts of ethylene glycol monobutyl ether and the mixture was neutralized with 3.0 parts of triethylamine and diluted with deionized water to obtain an aqueous dispersion having a solid content of 10% which was used as an electrodeposition bath in the following Example.

## Example 1

As cover-coat use, aqueous solutions or dispersions of high molecular weight substance, the following seven were provided.

(1) 3% aqueous solution of GL-05 (trademark, manufactured by Nippon Gosei Kagaku K.K.)
(2) 3% aqueous solution of Scripset resin 540 (Monsanto Co.) neutralized with $NH_4OH$
(3) 3% aqueous solution of Asahi Guard AG-710 (manufactured by Asahi Glass Co.)
(4) Aqueous dispersion of a mixture of Gohsenol GL-05 and Asahi Guard 710 (each 3% in solid)
(5) The abovementioned (3) was added with monoethanolamine to adjust pH at 8.0
(6) The abovementioned (4) was added with monoethanolamine to adjust pH at 7.5
(7) Aqueous dispersion of a mixture of Scripset resin 540 and Asahi Guard AG-710 (each 3% in solid)

Using the electrodeposition liquid obtained in Manufacturing Example 1, an electrodeposition coating of a copper cladded laminate for printed circuit board use was carried out by connecting said laminate to an anode and charging a direct current at 100 volts for 120 seconds and the obtained electrodeposited coating was then washed with water to remove the remaining electrodeposition liquid from the coated surface.

Next, the washed plate was dipped in the abovementioned aqueous solution or dispersion of high molecular weight substance for 10 seconds to effect dip-coating of the high molecular weight substance and the coated plate was maintained in a drying oven maintained at 100° C for 5 minutes to obtain a photoresist film coated with a cover coat of about $1\mu$ thickness.

Seven experiments were repeated, each time with a different cover-coating use, aqueous solution or dispersion of high molecular weight substance selected from (1) to (7). Thus obtained products were then evaluated with respect to cover-coat uniformity (by visual evaluation), tackiness (by touching) and mask-peeling property (peeling-off easiness of mask from the photoresist layer, after exposure), and the test results were shown in Table 1.

Evaluation standards:
Cover-coat uniformity:

O... overall uniform coating
χ . . . no cover-coat at the periphery in 1cm width, due to repellent

Tackiness:

O... no tackiness, by finger touch, no blocking when piled
Δ. . . tackiness at periphery
χ . . . tackiness and blocking

Mask-peeling property:

O . . . easily separable from the exposed photoresist
χ . .. hardly separable from the exposed photoresist

As is clear from the Table 1, with an aqueous coating composition with pH of 7 or less, no coating was obtained at the periphery of the photoresist film because of undesired repellent and the resulted coating showed undesired tackiness. Asahi Guard AG-710 showed excellent result in tackiness even under high-humidity conditions, but other solutions containing no AG-710 showed undesired tackiness under 70% humidity conditions under inferior mask-peeling property.

Table 1

| Test | resinous composition | solid content | pH | cover-coat uniformity | tackiness | | Mask-peeling | |
|---|---|---|---|---|---|---|---|---|
| | | | | | humidity 50% | humidity 70% | humidity 50% | humidity 70% |
| 1 | GL-05 | 3% | 6.2 | ✕ | ◯ | ✕ | ◯ | ✕ |
| 2 | SCRIPSET-540 | 3% | 7.8 | ◯ | ◯ | ✕ | ◯ | ✕ |
| 3 | AG-710 | 3% | 3.5 | ✕ | △ | △ | ✕ | ✕ |
| 4 | GL-05 + AG-710 | 6% | 5.4 | ✕ | △ | △ | ✕ | ✕ |
| 5 | AG-710 + MEA | 3% | 8.0 | ◯ | ◯ | ◯ | ◯ | ◯ |
| 6 | GL-05 + AG-710 + MEA | 6% | 7.5 | ◯ | ◯ | ◯ | ◯ | ◯ |
| 7 | SCRIPSET-540 + AG-710 | 6% | 7.4 | ◯ | ◯ | ◯ | ◯ | ◯ |

## Claims

1. In a method for forming a photoresist with a cover coat comprising the step of forming a photosensitive resinous layer on a conductive board by means of anionic electrodeposition coating with an aqueous solution or dispersion of a photosensitive resinous composition and the step of coating on the photosensitive resinous layer with a cover coat of high molecular weight substance by means of a dip-coating, an improvement which is characterized in that the electrodeposited board is washed with water and then, without drying, is directly dipped into an aqueous dispersion of high molecular weight substance and then subjected to drying.

2. In a method for forming a photoresist with a cover coat comprising dipping a conductive board into an aqueous solution or dispersion of photosensitive resinous composition and effecting an anionic electrodeposition to obtain a photoresist layer on said board, washing, dipping the washed board into an aqueous dispersion of high molecular weight substance and drying, an improvement which is characterized in that the said aqueous dispersion of high molecular weight substance is a water dispersion comprising 100 to 30% by weight (in solid) of an acrylic polymer of perfluoro alkyl acrylate or methacrylate and other $\alpha,\beta$-ethylenically unsaturated monomer and 0 to 70% by weight (in solid) of a water-soluble high molecular weight compound, pH of which dispersion is controlled in a range of 7.0 to 9.0.

3. A method according to claim 1 wherein the said photosensitive resinous composition is of a photo-curing type, and comprises a water soluble or dispersible binder resin having an acid value of 30 to 200 and an average molecular weight of 1,000 to 50,000, acrylic monomer or oligomer having polymerizable unsaturation bond, a photo-polymerization initiator and a heat polymerization inhibitor.

4. A method according to claim 1 wherein the said photosensitive resinous composition is of a photo-decomposition type and comprises a water soluble or dispersible resin having o-quinone diazide groups or mixture of water-soluble or dispersible resin and o-quinone diazide compound.